# FASCICULE DE BREVET EUROPEEN

(11) **EP 2 425 379 B1**
(45) Date de publication et mention de la délivrance du brevet: **05.06.2013**
(21) Numéro de dépôt: 10727070.4
(22) Date de dépôt: 29.04.2010
(51) Int. Cl.: H01L 21/683

(54) **PROCÉDÉ DE FIXATION D'UN COMPOSANT ÉLECTRONIQUE SUR UN PRODUIT**
VERFAHREN ZUR ANBRINGUNG EINER ELEKTRONISCHEN KOMPONENTE AN EINEM PRODUKT
METHOD FOR ATTACHING AN ELECTRONIC COMPONENT TO A PRODUCT

(30) Priorité: 30.04.2009 FR 0952916
(43) Date de publication de la demande: 07.03.2012
(73) Titulaire: Commissariat à l'Énergie Atomique et aux Énergies Alternatives, 75015 Paris (FR); Seripress, 38160 Saint-Marcellin (FR)
(72) Inventeur: THOMAS, Sigrid, F-38400 Saint Martin D'heres (FR); THOMAS, Victor, F-38840 Saint Bonnet De Chavagne (FR)
(74) Mandataire: de Beaumont, Michel
(86) Numéro de dépôt international: PCT/FR2010/050823
(87) Numéro de publication internationale: WO 2010/125320

(56) Documents cités:
- EP-A1- 1 894 980
- EP-A2- 0 786 802
- EP-A2- 2 003 698
- WO-A1-2007/124611
- US-A1- 2003 124 769

## Description

### Domaine de l'invention

La présente invention concerne un procédé de fixation d'un composant électronique sur un produit et plus particulièrement un procédé de fixation pouvant être mis en oeuvre après fabrication du produit, sans modification ni altération de ce produit.

### Exposé de l'art antérieur

La présente invention concerne plus particulièrement la fixation d'un composant électronique comprenant au moins une puce électronique de faibles dimensions, les dimensions de la puce étant telles qu'une manipulation manuelle de celle-ci est mal aisée. Une telle puce électronique est par exemple une puce utilisée pour la fabrication de cartes sans contact connues sous le nom de cartes RFID renvoyant à l'acronyme anglais de "Radio Frequency Identification Data", qui présentent généralement une épaisseur inférieure au millimètre (généralement quelques centaines de micromètres), et un volume inférieur au millimètre cube.

Dans le cas des cartes sans contact, le composant électronique est constitué d'une puce électronique reliée à une antenne. La fixation d'un tel composant électronique sur un produit est généralement réalisé au moyen d'un auto-collant. La fabrication d'un tel auto-collant comprend au moins une étape de fabrication de l'antenne puis une étape de positionnement de la puce électronique sur deux plots conducteurs formés en même temps que l'antenne, dans le prolongement de celle-ci. Le positionnement de la puce nécessite des appareils très précis et onéreux afin de positionner les puces à quelques centaines, voire quelques dizaines de micromètres près.

Outre la complexité de réalisation d'un tel auto-collant, ce type de procédé de fixation ne convient pas à tous les types de produits, notamment à des produits tels qu'un habit susceptible d'être lavé.

Le document US 2003/124769 décrit un procédé de fixation d'un composant électronique utilisant une feuille de transfert.

Le document EP 0786802 décrit une feuille de transfert.

Un objet de la présente invention est de prévoir un procédé de fixation d'un composant électronique sur un produit qui soit simple à mettre en oeuvre et peu onéreux.

Un autre objet de la présente invention est de prévoir un procédé qui permette de fixer des puces électroniques de petites dimensions sur un produit.

Un autre objet de la présente invention est de prévoir un procédé de fixation d'un composant électronique sur un produit qui permette d'assurer un bon maintien du composant électronique sur le produit lors de son utilisation.

Pour atteindre ces objets, la présente invention prévoit un procédé de fixation d'un composant électronique sur un produit mettant en oeuvre un procédé de transfert utilisant une feuille transfert comprenant une feuille support et au moins une couche transférable recouvrant une partie d'une face avant de la feuille support, le procédé de transfert consistant à placer la couche transférable en contact avec ledit produit, puis à appliquer une pression du côté de la face arrière de la feuille support et enfin à retirer la feuille support, ladite au moins une couche transférable restant collée sur le produit, le procédé comprenant une étape préalable au procédé de transfert consistant à positionner au moins un assemblage électronique comprenant au moins une puce électronique fixée sur au moins un fil entre le produit et la feuille support, de sorte qu'après retrait de la feuille support au moins une partie de chaque assemblage est maintenue par une couche transférable.

Selon un mode de mise en oeuvre du procédé susmentionné, au moins une portion d'un fil de chaque assemblage est maintenue par une couche transférable après retrait de la feuille support.

Selon un mode de mise en oeuvre du procédé susmentionné, le procédé comprend préalablement une étape d'insertion partielle ou totale d'au moins une partie de chaque assemblage dans une couche transférable de la feuille transfert, ledit au moins un assemblage électronique étant alors solidaire de ladite feuille transfert avant placement de la feuille transfert sur ledit produit.

Selon un mode de mise en oeuvre du procédé susmentionné, ladite au moins une partie de chaque assemblage est placée totalement ou partiellement dans une couche de colle de ladite couche transférable.

Selon un mode de mise en oeuvre du procédé susmentionné, au moins une partie de chaque assemblage est placée en contact avec une couche conductrice de ladite couche transférable.

Selon un mode de mise en oeuvre du procédé susmentionné, l'insertion totale ou partielle de ladite au moins une partie de chaque assemblage dans une couche transférable est réalisée au moyen d'une presse.

Selon un mode de mise en oeuvre du procédé susmentionné, lors du procédé de transfert, ladite couche transférable est à une température supérieure à la température de fusion de celle-ci.

La présente invention prévoit en outre une feuille transfert comprenant une feuille support et au moins une couche transférable recouvrant une partie d'une face avant de la feuille support, ladite au moins une couche transférable étant destinée à être apposée sur un produit au moyen d'une presse en pression du côté de la face arrière de la feuille support, la feuille transfert comprenant en outre au moins un assemblage électronique comprenant au moins une puce électronique fixée sur au moins un fil, ledit au moins un assemblage étant disposé de sorte qu'au moins une partie de chaque assemblage est maintenue par une couche transférable.

Selon un mode de réalisation de la feuille transfert susmentionnée, au moins une portion d'un fil de chaque assemblage est maintenue par une couche transférable.

Selon un mode de réalisation de la feuille transfert susmentionnée, au moins une couche transférable comprend au moins une couche conductrice, et dans laquelle au moins une portion d'un fil d'un assemblage est en contact avec une couche conductrice d'une couche transférable.

Selon un mode de réalisation de la feuille transfert susmentionnée, au moins une portion d'un fil d'un assemblage constitue tout ou partie d'une antenne.

Selon un mode de réalisation de la feuille transfert susmentionnée, au moins une puce d'un assemblage est connectée à une portion d'un fil constituant tout ou partie d'une antenne et comprend un circuit électronique apte à émettre et/ou recevoir des informations par l'intermédiaire de l'antenne à laquelle elle est connectée.

Selon un mode de réalisation de la feuille transfert susmentionnée, au moins une puce d'un assemblage comprend une diode électroluminescente.

Selon un mode de réalisation de la feuille transfert susmentionnée, au moins une puce électronique d'un assemblage comprend un capteur.

Selon un mode de réalisation de la feuille transfert susmentionnée, ledit au moins un assemblage est intégralement placé dans une couche transférable.

Selon un mode de réalisation de la feuille transfert susmentionnée, la dimension maximale de la puce électronique est inférieure au millimètre et le volume de la puce inférieure au millimètre cube.

Selon un mode de réalisation de la feuille transfert susmentionnée, au moins un fil sur lequel est fixée au moins une puce électronique présente une partie conductrice.

Selon un mode de réalisation de la feuille transfert susmentionnée, au moins une puce présente au moins une rainure, au moins un desdits au moins un fil sur lequel est fixée la puce considérée étant placé dans une rainure de cette puce.

Selon un mode de réalisation de la feuille transfert susmentionnée, au moins un plot conducteur est placé dans une rainure d'une puce électronique, le plot conducteur étant en contact électrique avec une partie conductrice d'un fil placé dans la rainure de la puce considérée.

Selon un mode de réalisation de la feuille transfert susmentionnée, ladite au moins une partie de chaque assemblage maintenue par une couche transférable présente une épaisseur inférieure à l'épaisseur de la couche transférable par laquelle elle est maintenue.

### Brève description des dessins

Ces objets, caractéristiques et avantages, ainsi que d'autres de la présente invention sont exposés en détail dans la description suivante de modes de réalisation particuliers faite à titre non-limitatif en relation avec les figures jointes parmi lesquelles:

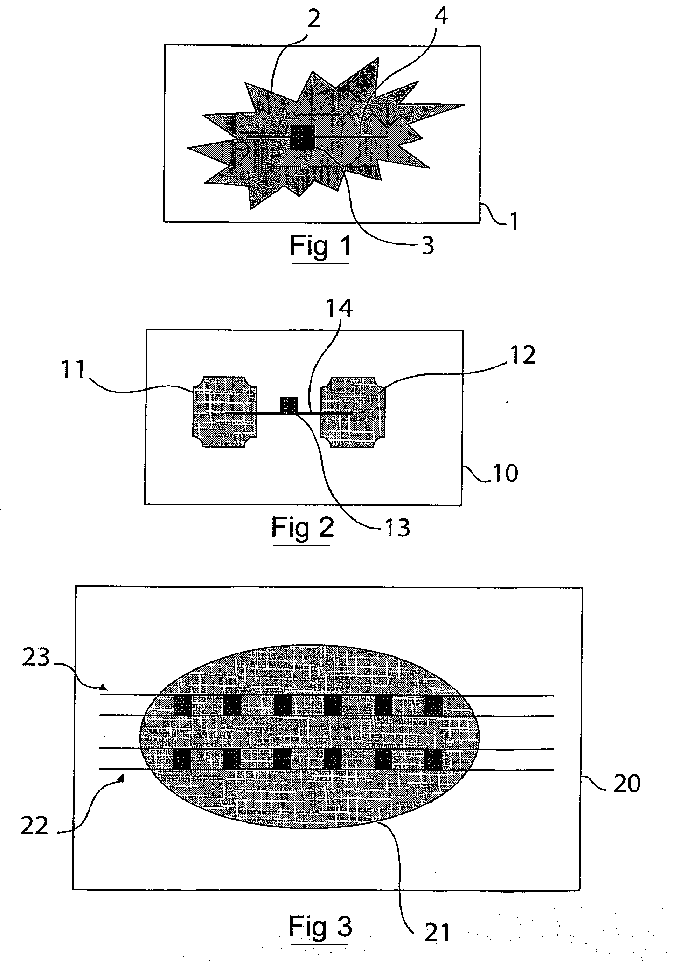

les figures 1 à 6 sont des vues de dessus de plusieurs modes de réalisation d'une feuille transfert selon la présente invention.

### Description détaillée

Par souci de clarté, les mêmes éléments sont désignés aux différentes figures par de mêmes références. En outre, les différentes figures ne sont pas représentées à l'échelle.

Le procédé de fixation de la présente invention vise à fixer un composant électronique sur un produit en mettant en oeuvre un procédé de transfert utilisant une feuille transfert. Une feuille transfert comprend une feuille support et au moins une couche transférable recouvrant une partie d'une face avant de la feuille support. Le procédé de transfert consiste à placer la feuille transfert sur le produit de sorte que la couche transférable est en contact avec le produit, puis à appliquer une pression du côté de la face arrière de la feuille support afin que la couche transférable se colle sur le produit. Une fois la couche transférable collée sur le produit, la feuille support est retirée.

Une couche transférable d'une feuille transfert est classiquement constituée d'un empilement d'une couche d'encre généralement colorée et d'une couche de colle. La couche d'encre colorée peut être constituée en pratique de plusieurs couches d'encres de différentes couleurs, ainsi que d'une couche d'encre de base, généralement blanche, évitant les effets de transparence une fois la couche transférable collée sur le produit.

La feuille support d'une feuille transfert est recouverte d'un revêtement anti-adhérent de sorte que, dans les conditions de pose du transfert sur le produit, la couche transférable adhère davantage au produit et se colle sur celui-ci, sans se décoller du produit au moment où la feuille support est retirée.

Lors de la mise en oeuvre du procédé de transfert, on utilise de préférence un moyen de chauffage de la couche transférable, ainsi qu'une feuille transfert comprenant des couches transférables dont la couche de colle présente un point de fusion élevé, au moins égal à 80°C et de préférence supérieure à 120°C. Les moyens de chauffage sont alors prévus pour chauffer les couches transférables au-dessus de leur point de fusion. Un tel procédé de transfert à chaud permet d'obtenir une couche transférable plus résistante une fois posée sur le produit, par exemple lors d'un lavage.

Par ailleurs, le procédé de la présente invention vise à fixer sur un support un composant électronique comprenant au moins un assemblage électronique, chaque assemblage électronique comprenant au moins une puce électronique fixée sur au moins un fil. Lors de la mise en oeuvre du procédé de fixation selon la présente invention, chaque assemblage est positionné de sorte qu'après mise en oeuvre du procédé de transfert, au moins une partie de chaque assemblage est maintenue sur le produit par une couche transférable.

Selon un premier mode de mise en oeuvre du procédé de fixation selon la présente invention, on commence par placer au moins un assemblage électronique sur un produit. On met ensuite en oeuvre un procédé de transfert en plaçant une feuille transfert sur le produit, de sorte que, pour chaque assemblage, au moins une couche transférable recouvre une partie de l'assemblage considéré. Une fois que la ou les couches transférables de la feuille transférable sont collées sur le produit, on retire la feuille support. Chaque assemblage est alors maintenu sur le produit par au moins une couche transférable.

Selon un deuxième mode de mise en oeuvre du procédé de fixation selon la présente invention, on effectue, préalablement au procédé de transfert, une étape d'insertion partielle ou totale d'au moins une partie de chaque assemblage dans une couche transférable d'une feuille transfert. Cette insertion peut être réalisée après la fabrication de la feuille transfert ou pendant la fabrication de celle-ci.

Un avantage de ce deuxième mode de mise en oeuvre du procédé de fixation est qu'il facilite le positionnement de chaque assemblage sur ou dans une couche transférable.

Dans la suite de la description, on appelle "partie de maintien", l'ensemble des éléments d'un assemblage électronique destinés à être maintenus par au moins une couche transférable. Tout ou partie d'un assemblage peut ainsi être maintenu par une ou plusieurs couches transférables. Autrement dit, une partie de maintien d'un assemblage peut inclure tout ou partie de cet assemblage.

Dans le cas où l'insertion est réalisée après la fabrication de la feuille transfert, on pourra par exemple positionner chaque assemblage sur la ou les couches transférables et appliquer une pression de façon à faire pénétrer la partie de maintien de l'assemblage dans la ou les couches transférables. La couche de colle en partie supérieure d'une couche transférable peut avantageusement être prévue suffisamment épaisse de sorte que la totalité de la partie de maintien d'un assemblage soit intégralement insérée dans cette couche de colle.

Dans le cas, entre autres, où la couche de colle est une colle thermofusible on pourra chauffer cette couche de colle lors de l'insertion de la partie de maintien de l'assemblage, ou après insertion dans la couche de colle, afin qu'après refroidissement, l'assemblage soit collé à cette couche de colle.

Dans le cas où l'insertion est réalisée pendant la fabrication de la feuille transfert, on pourra par exemple placer la partie de maintien d'un assemblage sur ou dans une couche intermédiaire constitutive des couches transférables autre que la couche de colle finale. Une telle couche intermédiaire peut par exemple être une couche conductrice comme cela est illustré ci-après en relation avec certains modes de réalisation de l'invention. Dans ce cas, la partie de maintien d'un assemblage sera de préférence recouverte d'au moins une couche, par exemple la couche de colle, afin d'assurer une bonne fixation de l'assemblage sur le produit lors de la pose.

L'application d'une pression lors d'une opération d'insertion de la partie de maintien d'un assemblage peut avantageusement être réalisée au moyen d'une presse mécanique. En outre, pendant ou après l'opération d'insertion, un chauffage de la feuille transfert peut être prévu afin de favoriser le collage de la partie de maintien d'un assemblage. Ce chauffage peut être réalisé simultanément à une opération de pression, par exemple en utilisant une presse mécanique chauffante.

Un type d'assemblage pouvant avantageusement être utilisé dans la présente invention est un assemblage tel que ceux décrits dans les demandes de brevet WO2008/025889 et W02009/013409. Un tel assemblage utilise des puces électroniques présentant au moins une rainure sur une de leurs faces. Une ou plusieurs puces sont alors fixées à un ou plusieurs fils, chaque fil étant placé dans une rainure. La fixation de la puce sur le fil, ou réciproquement, est assuré dans chaque rainure par des moyens mécaniques (serrage, crochetage...) et/ou par des moyens de collage.

Un tel procédé permet de concevoir des assemblages de faible épaisseur. En effet, il est possible de fixer des puces présentant une épaisseur de quelques centaines de micromètres, typiquement de 200 à 600 micromètres, sur des fils présentant un diamètre de l'ordre de 50 à 300 micromètres.

De façon générale, chaque assemblage comprend au moins un fil support ayant pour fonction de permettre une manipulation aisée de l'assemblage. Afin de faciliter le positionnement d'un assemblage, lors de la mise en oeuvre du procédé de l'invention, on utilisera de préférence un assemblage comprenant au moins deux fils support, chaque puce électronique étant fixée sur au moins deux fils support fixés en différents points de la puce. Dans le cas où l'assemblage utilisé correspond au type d'assemblage décrit dans les demandes de brevet susmentionnées, on pourra par exemple placer deux fils support dans des rainures ménagées dans des faces latérales opposées de chaque puce électronique.

Un avantage du procédé de la présente invention est qu'il permet une manipulation aisée des puces électroniques de par l'utilisation d'au moins un fil support. Le procédé de la présente invention permet une manipulation manuelle de petites puces électroniques dont la dimension maximale n'excède pas le millimètre.

En outre, chaque assemblage peut comprendre des fils ayant une autre fonction que celle de fil support. Un tel fil peut par exemple être un fil conducteur destiné à former une antenne reliée à une puce électronique ou un fil d'alimentation d'au moins une puce de l'assemblage ou un bus de transmission de données entre puces ou entre les puces et un dispositif extérieur à l'assemblage. De façon avantageuse, un fil pourra remplir plusieurs fonctions, à savoir une fonction de support, d'antenne, d'alimentation, de transmission de données ou autre.

Un autre avantage du procédé de la présente invention est qu'il permet de réaliser un grand nombre d'assemblages électroniques pouvant présenter des fonctions très diverses comme cela apparaîtra davantage à la lecture des exemples de réalisation de feuilles transfert décrits ci-après.

Dans tous les modes de réalisation décrits ci-après, chaque feuille transfert comprend une feuille support, représentée par un rectangle, recouverte d'au moins une couche transférable représentée en gris. Les puces électroniques sont représentées par des petits carrés noirs. Le ou les fils sur lesquels sont fixées les puces sont représentés par des traits noirs.

La figure 1 illustre une feuille transfert comprenant une feuille support 1 recouverte d'une couche transférable 2. Un assemblage constitué d'une puce 3 fixée à un fil 4 est placé dans la couche transférable 2. L'intégralité de l'assemblage est placée dans la couche transférable 2. Ainsi, lorsque la couche transférable sera posée sur un produit, l'assemblage peut être rendu invisible et/ou imperceptible au toucher.

Pour que l'assemblage soit imperceptible au toucher il faut que l'épaisseur de la puce 3 et celle du fil soient du même ordre de grandeur, et mieux inférieure à l'épaisseur de la couche transférable. En pratique, une couche transférable d'une feuille transfert constituée d'un ensemble de couches d'encre colorées, d'une couche de base blanche et d'une couche de colle, présente une épaisseur de quelques centaines de micromètres. Dans le cas particulier d'une feuille transfert comprenant une feuille support présentant une couche de mini-composants agglomérés, tels que des poils (couramment appelés FLOC) ou des micro billes, une couche transférable peut avoir une épaisseur de l'ordre du millimètre, voire quelques millimètres après pose sur le produit. L'épaisseur d'un assemblage pouvant être de quelques centaines de micromètres, il est possible de rendre cet assemblage imperceptible au toucher une fois placé sur le produit.

Par ailleurs, l'assemblage peut être invisible si l'assemblage est recouvert après pose d'une couche suffisamment opaque. En pratique une couche transférable comprenant une couche de base blanche est suffisante pour rendre un assemblage invisible dans des conditions d'éclairage standard d'une habitation.

En outre, dans le cas où un assemblage comprend une puce susceptible d'émettre de la lumière, telle qu'une diode électroluminescence (acronyme anglais LED), on pourra placer celle-ci sous une couche qui permet de rendre la puce invisible quand elle n'émet pas de lumière et permet de laisser passer, et mieux de diffuser, la lumière émise par la puce. Les couches de base blanche généralement utilisée dans la fabrication de transfert permettent d'obtenir un tel effet. Ainsi, à partir d'une LED de petite dimension, 300 ou 400 micromètres, il est possible de former une "tache" lumineuse de plusieurs millimètres voire d'un centimètre.

La figure 2 illustre une feuille transfert comprenant une feuille support 10 recouverte de deux couches transférables 11, 12. La feuille transfert comprend un assemblage constitué d'une unique puce 13 fixée à un fil 14 s'étendant de part et d'autre de la puce 13. Les extrémités du fil 14 sont respectivement placées dans les couches transférables 11 et 12. La puce 13 est quant à elle placée au-dessus de la feuille support, entre les couches transférables 11 et 12.

Dans cet exemple, la puce sera apparente une fois les couches transférables posées sur le produit. L'assemblage sera maintenu sur le produit par les deux extrémités de fils noyés dans les couches transférables. Ce type de réalisation peut être intéressant dans le cas où l'on souhaite pouvoir retirer la puce du produit. Une telle puce peut par exemple être une puce RFID qui est utile pendant la fabrication du produit, son conditionnement, son transport, sa mise en vente, mais devient inutile, voire non souhaitée, une fois le produit vendu.

La figure 3 illustre une feuille transfert comprenant une feuille support 20 recouverte d'une couche transférable 21. Deux assemblages électroniques 22 et 23 sont placés dans la couche transférable 21. Chaque assemblage comprend 6 puces électroniques fixées chacune sur deux fils support communs. Les fils support s'étendent au-delà de la couche transférable.

Un assemblage peut par exemple être constitué de 6 diodes électroluminescentes et les deux fils prévus conducteurs. Une fois les couches transférables et l'assemblage posé sur le produit, les fils support conducteurs peuvent être reliés à une alimentation électrique, les fils étant par exemple reliés respectivement à la masse et à une tension d'alimentation.

Un autre assemblage peut par exemple être constitué de puces électroniques de différents types, par exemple une puce constituant un capteur, une autre puce constituant un dispositif de récupération d'énergie, une autre puce constituant une unité de traitement de données. Ces puces peuvent être alimentées et échanger des données via les fils support prévus conducteurs. Il est possible également que les puces soient reliées les unes aux autres par un ou plusieurs autres fils conducteurs non représentés afin de réaliser séparément l'alimentation électrique des puces et le transfert de données.

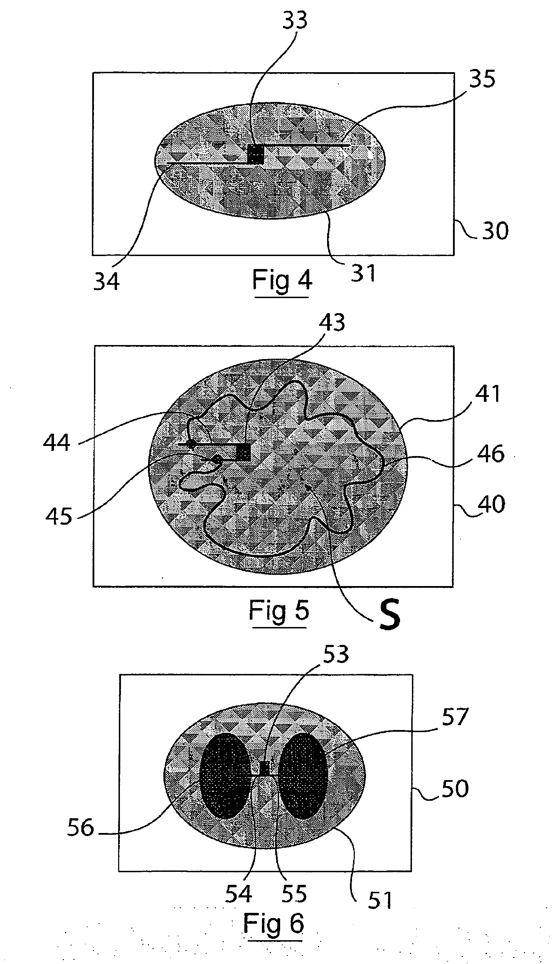

La figure 4 illustre une feuille transfert comprenant une feuille support 30 recouverte d'une couche transférable 31 dans laquelle est placé un assemblage comprenant une puce 33 fixée sur deux fils 34 et 35. Outre leur fonction de support, les fils constituent des éléments d'une antenne de type dipôle. Une extrémité de chaque fil est ainsi reliée à un plot conducteur de la puce électronique. La longueur des fils est définie en fonction de la longueur d'onde des signaux électromagnétiques que l'on souhaite émettre et ou recevoir, comme cela est connu de l'homme de l'art. On peut ainsi aisément placer sur un produit, une puce électronique reliée à une antenne permettant l'émission et/ou la réception de signaux électromagnétiques. Une telle puce est par exemple une puce RFID. Les deux fils constitutifs de l'antenne peuvent être placés en ligne, comme représenté, ou en forme de portion de cercle, d'ovale ou de spirale. Un exemple d'assemblage incluant une puce RFID reliée à deux fils conducteurs formant antenne est décrit dans la demande de brevet WO2008/051079.

La figure 5 illustre une feuille transfert comprenant une feuille support 40 recouverte d'une couche transférable 41 dans laquelle est placé un assemblage comprenant une puce 43 fixée sur deux fils conducteurs 44 et 45. Une bande conductrice 46 est prévue dans la couche transférable 41. La bande conductrice 46 est quasiment refermée sur elle-même en définissant une surface intérieure S. Les fils conducteurs 44 et 45 sont respectivement reliés aux extrémités de la bande conductrice 46, le fil conducteur 44 étant en contact électrique avec une première extrémité de la bande et le fil conducteur 45 en contact électrique avec une seconde extrémité de la bande. La bande conductrice et dans une moindre mesure les fils 44 et 45 constituent une antenne pouvant être reliée à la puce électronique 43 par des plots conducteurs placés sur la puce et en contact avec les fils 44 et 45. Ce type d'antenne, présentant une surface S relativement importante permet avantageusement de téléalimenter la ou les puces de l'assemblage auquel elles sont reliées.

La bande conductrice d'une telle feuille transfert peut être formée lors de la réalisation des différentes couches constitutives de la couche transférable. On pourra par exemple réaliser cette bande conductrice selon un procédé d'impression par sérigraphie.

La figure 6 illustre une feuille transfert comprenant une feuille support 50 recouverte d'une couche transférable 51 dans laquelle est placé un assemblage comprenant une puce 53 fixée sur deux fils conducteurs 54 et 55. La couche transférable 51 comprend en outre deux couches conductrices 56 et 57 présentant dans cet exemple une forme ovale. Le fil conducteur 54 est en contact, du côté d'une de ses extrémités, avec la couche conductrice 56. De même, le fil conducteur 55 est en contact, du côté d'une de ses extrémités, avec la couche conductrice 57. Les autres extrémités des fils 54 et 55 sont chacune en contact électrique avec un plot conducteur de la puce 53. Les couches conductrices 56 et 57 constituent les éléments principaux d'une antenne d'émission-réception d'un signal électromagnétique.

On notera que la forme des couches conductrices 56 et 57 est illustrative et en aucun cas limitative. Au contraire, de nombreuses autres formes peuvent être utilisées en fonction du type d'antenne souhaité: fréquence de fonctionnement, bande passante, facteur de qualité...

Un avantage du procédé de la présente invention est qu'il permet de réaliser et de fixer simplement sur un produit un assemblage comprenant une puce électronique reliée à une antenne.

D'autres modes de réalisation d'une feuille transfert selon la présente invention peuvent être imaginés par l'homme de l'art, ainsi que d'autres procédés d'application d'une telle feuille transfert.

En outre, les fils utilisés pour la réalisation des assemblages peuvent présenter des sections de différentes formes. Le fil peut par exemple prendre la forme d'une bande mince et étroite.

Afin de pouvoir mettre en oeuvre le procédé de la présente invention avec des feuilles transfert classiques comprenant une couche d'encre colorée recouverte d'une couche de colle, il est nécessaire que les portions de fil et les puces placées dans une couche transférable présentent une largeur suffisamment petite afin que l'intégralité de la couche transférable se détache correctement de la feuille support lors de la pose sur un produit. En effet, si la largeur d'un fil ou d'une puce est trop grande, les portions de la couche transférable recouvertes par le fil ou la puce risquent de rester coller sur la feuille support et de ne pas se transférer sur le produit. Afin d'assurer une bonne fixation de chaque assemblage sur le produit, il faudra par conséquent qu'au moins une partie de l'assemblage soit suffisamment étroit pour assurer un bon transfert des couches transférables destinées à maintenir cet assemblage sur le produit. La partie de maintien de chaque assemblage a par conséquent une largeur maximale, parallèlement au plan de la feuille support, qui est de préférence inférieure au millimètre. Divers types de puces électroniques peuvent être utilisés pour réaliser des assemblages pouvant être fixés selon le procédé de la présente invention.

On pourra par exemple prévoir dans un assemblage électronique, un dispositif miniature de type capteur. Dans le domaine notamment des équipements de jeux ou d'aide à la personne, on pourra par exemple placer sur un habit ou autre, des capteurs de type magnétomètres, accéléromètres, gyromètres. Les capteurs peuvent aussi être des capteurs chimiques, par exemple des capteurs de sudation. On peut également utiliser des capteurs de température et de pression.

On pourra également prévoir dans un assemblage électronique, un dispositif miniature de récupération d'énergie. De tels récupérateurs d'énergie peuvent par exemple fournir une alimentation électrique à d'autres puces de l'assemblage en récupérant de l'énergie d'un mouvement mécanique, vibrations, chocs de particules d'eau ou en récupérant de l'énergie solaire ou thermique.

On pourra en outre prévoir dans un assemblage électronique un dispositif miniature de type actionneur qui soit par exemple apte à délivrer une décharge électrique.

Par ailleurs, il est possible d'appliquer le procédé de la présente invention sur divers types de produits tels qu'un habit, un équipement, un produit manufacturé, un mur...

Un avantage du procédé de la présente invention est qu'il permet simplement de personnaliser un équipement en lui fixant un assemblage électronique pouvant être défini spécifiquement.

## Revendications

1. Procédé de fixation d'un composant électronique sur un produit **caractérisé en ce qu'**il met en oeuvre un procédé de transfert utilisant une feuille transfert comprenant une feuille support (1 ; 10 ; 20 ; 30 ; 40 ; 50) et au moins une couche transférable (2 ; 11 ; 12 ; 21 ; 31 ; 41 ; 51) recouvrant une partie d'une face avant de la feuille support, le procédé de transfert consistant à placer la couche transférable en contact avec ledit produit, puis à appliquer une pression du côté de la face arrière de la feuille support et enfin à retirer la feuille support, ladite au moins une couche transférable restant collée sur le produit, et **en ce qu'**il comprend une étape préalable au procédé de transfert consistant à positionner au moins un assemblage électronique (22, 23) comprenant au moins une puce électronique (3 ; 13 ; 33 ; 43 ; 53) fixée sur au moins un fil (4 ; 14 ; 34, 35 ; 44, 45 ; 54, 55) entre le produit et la feuille support, de sorte qu'après retrait de la feuille support au moins une partie de chaque assemblage est maintenue par une couche transférable.

2. Procédé de fixation selon la revendication 1, dans lequel au moins une portion d'un fil de chaque assemblage est maintenue par une couche transférable après retrait de la feuille support.

3. Procédé de fixation selon l'une des revendications précédentes, comprenant préalablement une étape d'insertion partielle ou totale d'au moins une partie de chaque assemblage dans une couche transférable de la feuille transfert, ledit au moins un assemblage électronique étant alors solidaire de ladite feuille transfert avant placement de la feuille transfert sur ledit produit.

4. Procédé de fixation selon l'une des revendications précédentes, dans lequel ladite au moins une partie de chaque assemblage est placée totalement ou partiellement dans une couche de colle de ladite couche transférable.

5. Procédé de fixation selon l'une des revendications précédentes, dans lequel au moins une partie de chaque assemblage est placée en contact avec une couche conductrice de ladite couche transférable.

6. Procédé de fixation selon la revendication 3, dans lequel l'insertion totale ou partielle de ladite au moins une partie de chaque assemblage dans une couche transférable est réalisée au moyen d'une presse.

7. Procédé de fixation selon l'une des revendications précédentes, dans lequel lors du procédé de transfert ladite couche transférable est à une température supérieure à la température de fusion de celle-ci.

8. Feuille transfert comprenant une feuille support (1 ; 10 ; 20 ; 30 ; 40 ; 50) et au moins une couche transférable (2 ; 11, 12 ; 21 ; 31 ; 41 ; 51) recouvrant une partie d'une face avant de la feuille support, ladite au moins une couche transférable étant destinée à être apposée sur un produit au moyen d'une presse en pression du côté de la face arrière de la feuille support, **caractérisée en ce qu'**elle comprend en outre au moins un assemblage électronique (22, 23) comprenant au moins une puce électronique (3 ; 13 ; 33 ; 43 ; 53) fixée sur au moins un fil (4 ; 14 ; 34, 35 ; 44, 45 ; 54, 55), et **en ce qu'**au moins une partie de chaque assemblage est maintenue par une couche transférable.

9. Feuille transfert selon la revendication 8, dans laquelle au moins une portion d'un fil de chaque assemblage est maintenue par une couche transférable.

10. Feuille transfert selon l'une des revendications 8 à 9, dans laquelle au moins une couche transférable comprend au moins une couche conductrice (46 ; 56, 57), et dans laquelle au moins une portion d'un fil d'un assemblage est en contact avec une couche conductrice d'une couche transférable.

11. Feuille transfert selon l'une des revendications 8 à 10, dans laquelle au moins une portion d'un fil (34, 35 ; 44, 45 ; 54, 55) d'un assemblage constitue tout ou partie d'une antenne.

12. Feuille transfert selon la revendication 11, dans laquelle au moins une puce d'un assemblage est connectée à une portion d'un fil constituant tout ou partie d'une antenne et comprend un circuit électronique apte à émettre et/ou recevoir des informations par l'intermédiaire de l'antenne à laquelle elle est connectée.

13. Feuille transfert selon l'une des revendications 8 à 12, dans laquelle au moins une puce d'un assemblage comprend une diode électroluminescente.

14. Feuille transfert selon l'une des revendications 8 à 13, dans laquelle au moins une puce électronique d'un assemblage comprend un capteur.

15. Feuille transfert selon l'une des revendications 8 à 14, dans laquelle ledit au moins un assemblage est intégralement placé dans une couche transférable.

16. Feuille transfert selon l'une des revendications 8 à 15, dans laquelle la dimension maximale de la puce électronique est inférieure au millimètre et le volume de la puce inférieure au millimètre cube.

17. Feuille transfert selon l'une des revendications 8 à 16, dans laquelle au moins un fil sur lequel est fixée au moins une puce électronique présente une partie conductrice.

18. Feuille transfert selon l'une des revendications 8 à 17, dans laquelle au moins une puce présente au moins une rainure, au moins un desdits au moins un fil sur lequel est fixée la puce considérée étant placé dans une rainure de cette puce.

19. Feuille transfert selon les revendications 17 et 18, dans laquelle au moins un plot conducteur est placé dans une rainure d'une puce électronique, le plot conducteur étant en contact électrique avec une partie conductrice d'un fil placé dans la rainure de la puce considérée.

20. Feuille transfert selon les revendications 8 et 19, dans laquelle ladite au moins une partie de chaque assemblage maintenue par une couche transférable présente une épaisseur inférieure à l'épaisseur de la couche transférable par laquelle elle est maintenue.

## Patentansprüche

1. Ein Verfahren zur Anbringung einer elektronischen Komponente an einem Produkt, **dadurch gekennzeichnet, dass** das Verfahren ein Transferverfahren implementiert unter Verwendung eines Transferflächenelements, welches ein Tragblatt bzw. Tragflächenelement (1; 10; 20; 30; 40; 50) und mindestens eine transferierbare Schicht (2; 11; 12; 21; 31; 41; 51) aufweist, und zwar ein Teil einer Vorderoberfläche des Tragblatts abdeckend, wobei das Transferverfahren die Platzierung der transferierbaren Schicht in Kontakt mit dem erwähnten Produkt aufweist, so dann die Anbringung eines Drucks an der hinteren Oberflächenseite des Tragblattes und schließlich die Entfernung des Tragblattes, wobei die erwähnte mindestens eine transferierbare Schicht mit dem Produkt verbunden bleibt und ferner **dadurch gekennzeichnet, dass** das Verfahren einen Schritt vor dem Transferverfahren aufweist, welches die Positionierung von mindestens einer elektronischen Anordnung (22, 23) aufweist, die mindestens ein elektronisches Chip (3; 13; 33; 43; 53) angebracht an mindestens einem Draht (4; 14; 34, 35; 44, 45; 54, 55) zwischen dem Produkt und dem Tragblatt derart aufweist, dass nach der Entfernung des Tragblattes mindestens ein Teil jeder Anordnung durch eine transferierbare Schicht gehalten ist.

2. Anbringungsverfahren nach Anspruch 1, wobei mindestens ein Teil eines Drahtes jeder Anordnung durch die transferierbare Schicht nach der Entfernung des Tragblattes gehalten ist.

3. Anbringungsverfahren nach einem der vorhergehenden Ansprüche, vorausgehend einen Schritt aufweisend und zwar des partiellen oder totalen Einsetzens von mindestens einem Teil jeder Anordnung in eine transferierbare Schicht des Transferblatts, wobei mindestens eine elektronische Anordnung so dann an dem erwähnten Transferblatt angebracht ist, bevor die Platzierung des Transferblatts auf dem Produkt erfolgt.

4. Anbringungsverfahren nach einem der vorhergehenden Ansprüche, wobei der erwähnte mindestens eine Teil jeder Anordnung insgesamt oder teilweise in einer Klebeschicht der erwähnten transferierbaren Schicht platziert ist.

5. Anbringungsverfahren nach der vorhergehenden Ansprüche, wobei mindestens ein Teil jeder Anordnung in Kontakt mit einer leitenden Schicht der transferierbaren Schicht platziert ist.

6. Anbringungsverfahren nach Anspruch 3, wobei die total oder partielle Einsetzung des erwähnten mindestens einen Teils jeder Anordnung in eine transferierbare Schicht mittels einer Presse ausgeführt wird.

7. Anbringungsverfahren nach einem der vorhergehenden Ansprüche, wobei während des Transferprozesses die transferierbare Schicht sich auf einer Temperatur befindet, die größer ist als seine Schmelztemperatur.

8. Ein Transferblatt, welches ein Tragblatt (1; 10; 20; 30; 40; 50) und mindestens eine transferierbare Schicht (2; 11, 12; 21; 31; 41; 51) aufweist, und zwar einen Teil der Vorderoberfläche des Tragblatts abdeckend, wobei die mindestens eine transferierbare Schicht dazu vorgesehen ist, auf einem Produkt platziert zu werden, und zwar mittels einer Presse, die auf die hintere Oberflächenseite des Tragblattes presst, **dadurch gekennzeichnet, dass** es ferner mindestens eine elektronische Anordnung (22, 23) aufweist, die mindestens ein elektronisches Chip (3; 13; 33; 43; 53) angebracht an mindestens einem Draht (4; 14; 34, 35; 44, 45; 54, 55) besitzt und dadurch, dass mindestens ein Teil jeder Anordnung durch eine transferierbare Schicht gehalten ist.

9. Das Transferblatt nach Anspruch 8, wobei mindestens ein Teil eines Drahtes jeder Anordnung durch eine transferierbare Schicht gehalten ist.

10. Das Transferblatt nach Anspruch 8 oder 9, wobei die mindestens eine transferierbare Schicht mindestens eine leitende Schicht (46; 56, 57) aufweist, und wobei mindestens ein Teil eines Drahtes einer Anordnung in Kontakt mit einer leitenden Schicht der transferierbaren Schicht steht.

11. Das Transferblatt nach einem der Ansprüche 8 bis 10, wobei mindestens ein Teil eines Drahtes (34, 35; 44, 45; 54, 55) einer Anordnung die Gesamtheit oder einen Teil einer Antenne bildet.

12. Das Transferblatt nach Anspruch 11, wobei mindestens ein Chip einer Anordnung mit einem Teil eines Drahtes verbunden ist, der eine ganze oder einen Teil einer Antenne bildet und eine elektronische Schaltung aufweist, die in der Lage ist, Daten über die Antenne zu senden und/oder zu empfangen und zwar die Antenne mit der sie verbunden ist.

13. Das Transferblatt nach einem der Ansprüche 8 bis 12, wobei mindestens ein Chip einer Anordnung eine lichtemittierende Diode aufweist.

14. Das Transferblatt nach einem der Ansprüche 8 bis 13, wobei mindestens ein elektronisches Chip einer Anordnung einen Sensor aufweist.

15. Das Transferblatt nach einem der Ansprüche 8 bis 14, wobei die erwähnte mindestens eine Anordnung integral in einer transferierbaren Schicht platziert ist.

16. Das Transferblatt nach einem der Ansprüche 8 bis 15, wobei die maximale Dimension des elektronischen Chips kleiner ist als ein Millimeter und das Volumen des Chips kleiner ist als ein Kubikmillimeter.

17. Das Transferblatt nach einem der Ansprüche 8 bis 16, wobei mindestens ein Draht an dem das mindestens eine elektronische Chip angebracht ist, einen leitenden Teil aufweist.

18. Das Transferblatt nach einem der Ansprüche 8 bis 17, wobei das mindestens eine Chip mindestens eine Nut besitzt, wobei mindestens ein Draht des mindestens einen Drahts auf dem das in Betracht gezogene Chip befestigt ist, in einer Nut dieses Chips angeordnet ist.

19. Das Transferblatt nach Anspruch 17 und 18, wobei mindestens ein leitender Anschluss in einer Nut eines elektronischen Chips platziert ist, wobei der leitende Anschluss im elektrischen Kontakt mit dem leitenden Teil eines Drahtes platziert in der Nut des betrachtenden Chips ist.

20. Das Transferblatt nach Anspruch 8 und 19, wobei der erwähnte mindestens eine Teil jeder Anordnung durch eine transferierbare Schicht gehalten wird, die eine Dicke besitzt, die kleiner ist als die Dicke der transferierbaren Schicht durch die er gehalten wird.

## Claims

1. A method for attaching an electronic component to a product, **characterized in that** it implements a transfer method using a transfer sheet comprising a support sheet (1; 10; 20; 30; 40; 50) and at least one transferrable layer (2; 11; 12; 21; 31; 41; 51) covering a portion of a front surface of the support sheet, the transfer method comprising placing the transferrable layer in contact with said product, then applying a pressure on the rear surface side of the support sheet, and finally removing the support sheet, said at least one transferrable layer remaining bonded to the product, and **in that** it comprises a step prior to the transfer method, comprising positioning at least one electronic assembly (22, 23) comprising at least one electronic chip (3; 13; 33; 43; 53) attached to at least one wire (4; 14; 34, 35; 44, 45; 54, 55) between the product and the support sheet, so that after removal of the support sheet, at least a portion of each assembly is maintained by a transferrable layer.

2. The attachment method of claim 1, wherein at least a portion of a wire of each assembly is maintained by a transferrable layer after removal of the support sheet.

3. The attachment method of any of the foregoing claims, previously comprising a step of partial or total insertion of at least a portion of each assembly into a transferrable layer of the transfer sheet, said at least one electronic assembly being then attached to said transfer sheet before placing of the transfer sheet on said product.

4. The attachment method of any of the foregoing claims, wherein said at least a portion of each assembly is totally or partially placed in an adhesive layer of said transferrable layer.

5. The attachment method of any of the foregoing claims, wherein at least a portion of each assembly is placed in contact with a conductive layer of said transferrable layer.

6. The attachment method of claim 3, wherein the total or partial insertion of said at least a portion of each assembly into a transferrable layer is performed by means of a press.

7. The attachment method of any of the foregoing claims, wherein, during the transfer process, said transferrable layer is at a temperature greater than its melting temperature.

8. A transfer sheet comprising a support sheet (1; 10; 20; 30; 40; 50) and at least one transferrable layer (2; 11, 12; 21; 31; 41; 51) covering a portion of a front surface of the support sheet, said at least one transferrable layer being intended to be placed on a product by means of a press pressing on the rear surface side of the support sheet, **characterized in that** it further comprises at least one electronic assembly (22, 23) comprising at least one electronic chip (3; 13; 33; 43; 53) attached to at least one wire (4; 14; 34, 35; 44, 45; 54, 55), and **in that** at least a portion of each assembly is maintained by a transferrable layer.

9. The transfer sheet of claim 8, wherein at least a portion of a wire of each assembly is maintained by a transferrable layer.

10. The transfer sheet of claim 8 or 9, wherein said at least one transferrable layer comprises at least one conductive layer (46; 56, 57), and wherein at least a portion of a wire of an assembly is in contact with a conductive layer of a transferrable layer.

11. The transfer sheet of any of claims 8 to 10, wherein at least a portion of a wire (34, 35; 44, 45; 54, 55) of an assembly forms all or part of an antenna.

12. The transfer sheet of claim 11, wherein at least a chip of an assembly is connected to a portion of a wire forming all or part of an antenna and comprises an electronic circuit capable of transmitting and/or receiving data via the antenna to which it is connected.

13. The transfer sheet of any of claims 8 to 12, wherein at least one chip of an assembly comprises a light-emitting diode.

14. The transfer sheet of any of claims 8 to 13, wherein at least one electronic chip of an assembly comprises a sensor.

15. The transfer sheet of any of claims 8 to 14, wherein said at least one assembly is integrally placed in a transferrable layer.

16. The transfer sheet of any of claims 8 to 15, wherein the maximum dimension of the electronic chip is smaller than one millimeter and the volume of the chip is smaller than one cubic millimeter.

17. The transfer sheet of any of claims 8 to 16, wherein at least one wire to which at least one electronic chip is attached has a conductive portion.

18. The transfer sheet of any of claims 8 to 17, wherein said at least one chip has at least one groove, at least one of said at least one wire on which is attached the considered chip being placed in a groove of this chip.

19. The transfer sheet of claims 17 and 18, wherein at least one conductive pad is placed in a groove of an electronic chip, the conductive pad being in electric contact with the conductive portion of a wire placed in the groove of the considered chip.

20. The transfer sheet of claims 8 and 19, wherein said at least a portion of each assembly maintained by a transferrable layer has a thickness smaller than the thickness of the transferrable layer by which it is maintained.
